# EUROPEAN PATENT APPLICATION

(11) **EP 0 595 406 A1**
(43) Date of publication of application: **04.05.1994**
(21) Application number: 93202939.0
(22) Date of filing: 20.10.1993
(51) Int. Cl.: H04B 1/30

(54) **Radio device with signal compression**

(30) Priority: 26.10.1992 EP 92203277
(71) Applicant: Philips Electronics N.V., 5621 BA Eindhoven (NL); Philips Patentverwaltung GmbH, 22335 Hamburg (DE)
(72) Inventor: Marshall, Christopher, NL-5656 AA Eindhoven (NL); Sauer, Erich, NL-5656 AA Eindhoven (NL)
(74) Representative: De Jongh, Cornelis Dominicus

(57) **Abstract**

A digital radio device (2) for inter alia mobile radio or cordless telephony is proposed with signal compression (12) for base band signals and/or hardlimiting at RF (6) an/or IF (10) stages. Such an architecture allows for a high level of integration with less complexity than known digital radio devices, and is thus cost saving. In an embodiments of the present invention the signal compression (12) can be carried out by a true logarithmic amplifier or by a compression device (13, 14) having a sine-shaped transfer characteristic. In succesive signal processing (24) of digitised base band signals, digital signal decompression can be carried out by using the samples of the base band signal as addresses to a decompression lookup-table.

## Description

The present invention relates to a digital radio device comprising an analog receiving part for receiving phase or frequency modulated radio frequency signals coupled to base band conversion means for converting the radio frequency signals to at least one base band signal, analog to digital conversion means for sampling the at least one base band signal, and digital processing means for processing samples of the at least one base band signal. Such digital radio devices, which can be transceivers if also a transmitting part and switchover means for switching over between transmission and reception are comprised therein, can be used in mobile radio systems, in cordless telephony systems, and in paging systems inter alia.

A digital radio device of this kind is known from the German patent application DE-OS 39 25 305. In the known digital radio device signal compression and signal limiting is carried out before base band conversion and base band converted radio frequency quadrature signals are sampled by means of analog to digital converters. After analog to digital conversion digital samples are further processed in the known digital radio device. In the known radio device, e.g. to be used in a cellular radio system such as a so-called GSM-system (Groupe Special Mobile), a pan-European mobile radio system, signal compression is carried out to achieve dynamics compression of the radio frequency signal which may vary 100 dB at an antenna input of the radio device, in order to relieve analog to digital conversion of the quadrature base band signals. Without compression a 20 bit A/D-converter would be necessary for achieving the necessary number of significant bits at very small signal strength, i.e. such an A/D-converter would become very expensive. A disadvantage of the known signal limiting and compression is that when interfering signals are present the compression means introduce intermodulation products that one cannot get rid of during subsequent processing of the baseband samples. Bandpass filtering is therefore required before limiting and compression, implemented for example by a separate device like a SAW-filter (Surface Acoustic Wave).

It is an object of the present invention to provide a digital radio device in which inexpensive analog to digital converters are used, not having the disadvantages of the known digital radio device.

To this end a digital radio device according to the present invention is characterised in that the digital radio device comprises a smooth-non-linear arrangement coupled between the base band conversion means and the analog to digital conversion means for compressing larger signals at an input thereof more than smaller signals. By signal smoothing after base band conversion the smoothing arrangement consumes less power than the logarithmic compression in the known device, due to the lower frequency operating range, whereas limiting at RF and/or IF can at least substantially be avoided. Due to the base band smoothing no separate SAW-filter would be necessary, whereas the base band smoothing can be integrated with further functions, thus reducing costs by achieving a simplified device. It is to be realized that the dynamic range of an analog to digital converter is proportional to cost, IC surface area, and power consumption, or, otherwise stated, every extra bit doubles the complexity of an analog to digital converter.

In an embodiment of a digital radio device according to the present invention the smooth-non-linear arrangement is a logarithmic amplifier. By using a logarithmic amplifier, which should be of the so-called true logarithmic amplifier type which compresses the amplitude of an input signal while retaining information about its sign, very large amplitude range signals can be coped with.

In another embodiment of a digital radio device according to the present invention the smooth-non-linear arrangement is an arrangement having a sine-shaped transfer characteristic. Also with a sine-shaped transfer characteristic input signals with a larger amplitude are compressed with respect to smaller signals whilst hard limiting on base band signals is avoided. It is to be realised that hard limiting of base band signals would lead to phase errors and thus to an unacceptable increase of the BER (Bit Error Rate) of demodulated digital signals.

In a further embodiment of a digital radio device according to the present invention the digital radio device comprises at least one signal limiting arrangement in the analog receiving part. The limiting can be at higher signal levels not leading to substantial performance degradation in the base band processing due to interference caused by the presence of unwanted signals. By also adding some limiting at radio frequency and/or intermediate frequency maximum signal control for analog to digital conversion is achieved. The limiting can be done by means of hard limiting or by means of AGC (Automatic Gain Control). Fading signals can only demodulated correctly (by an equalizer) if amplitude information is preserved. However fading are only to be expected up to a certain field strength. Higher strengths are encountered when one is near a transmitter, and then one radio propagation path from the transmitter to the receiver tends to dominate, and fading is less significant. Under these circumstances of very high signal strength the signal amplitude can be limited without seriously affecting performance. This limiting is best done at r.f. or at an i.f. In order to avoid distortion of the signal phase that would occur with baseband limiting, and to reduce the dynamic range required in the later parts of the receiver.

In a further embodiment of a digital radio device according to the present invention the digital radio device comprises at least one low pass filter for filtering the at least one base band signal. It is achieved that unwanted signals are removed and that less demand is imposed on passband filtering. Also filtering at lower frequencies eases integration thereof on an IC (Integrated Circuit).

In a further embodiment of a digital radio device according to the present invention the digital radio device comprises at least one band pass filter before the at least one signal limiting arrangement. Band pass filtering, which can be carried out on radio frequency signals and/or intermediate frequencies, removes unwanted signals. Thus, filter effort can be distributed over various frequency bands, i.e. at radio frequency, at intermediate frequency, or at low frequency. Low pass filtering before the logarithmic amplifier can be dimensioned such that closest neighbour channel signals are attenuated such that a rest signal thereof has negligable effect on the dynamics compression.

In a further embodiment of a digital radio device according to the present invention, the digital processing means are arranged for correcting the samples of the at least one base band signal so as to decompress for compression by means of the smooth-non-linear arrangement. In this way a quasi linear result is achieved in which fine quantisation is achieved for very small signals, where noise plays a greater role, while greater quantisation steps are used for stronger fading signals, where less accuracy is required.

In a further embodiment of a digital radio device according to the present invention, the processing means are arranged for correcting the samples by using the samples as addresses for a correction lookup-table which outputs decompressed sample values. Use of a lookup-table allows for a fast software correction of digitised base band signals.

The present invention will now be described, by way of example, with reference to the accompanying drawings, wherein
Fig. 1 schematically shows a radio communication system with a digital radio device according to the present invention,
Fig. 2 diagrammatically shows an embodiment of a signal compression device for use in the digital radio device, and
Fig. 3 shows simulation results of bit error rates versus signal levels in a radio device according to the present invention under various conditions.

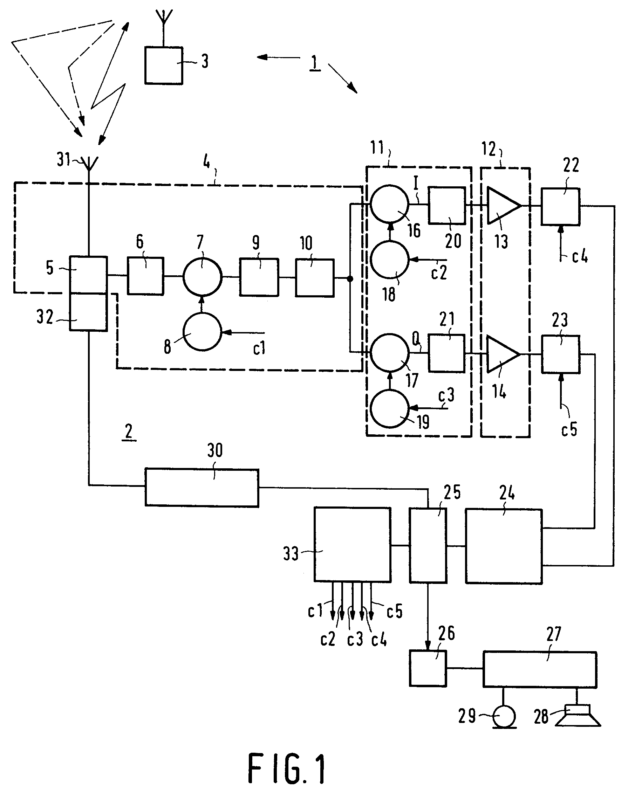

Figure 1 schematically shows a radio communication system 1 with a digital radio device 2 according to the present invention, and at least one radio base station of which a radio base station 3 is shown. The radio base station 3 communicates with the digital radio device 2, which comprises a receiving and a transmitting part, e.g. using a TDMA communication method such as used in GSM. It is pointed out in figure 1 by means of a solid line for a direct path and broken lines for reflected paths between the radio base station 3 and the digital radio device 2 that signals transmitted and received signals are subject to multipath propagation due to reflections inter alia, i.e. delayed replica of transmitted signals are received. Furthermore, for mobile digital radio devices, the radio signals are subject to fading of 40 dB or more, causing a very rapidly fluctuating signal strength at receiver side. It is thus important that the digital receiver 2 can cope with these land of problems. The digital radio receiver 2 comprises an analog receiving part 4 for receiving phase or frequency modulated signals, e.g. quadrature GMSK (Gaussian Minimum Shift Keying) modulated signals. The analog receiving part 4 comprises an RF-input-stage 5 which can be coupled to a signal limiting arrangement 6 in an embodiment of a digital radio device according to the present invention. The received and at choice limited signal is fed to an intermediate mixer which is coupled with a local oscillator 8. Although only one mixing stage 7 is shown, frequency down conversion may be carried out via several mixing stages. The mixer 7 is coupled to an intermediate stage 9 comprising a band pass filter which can be coupled to a further limiting arrangement 10. It has been shown that no further limiting than for signal levels above -40 dBm, preferably distributed over various intermediate frequencies, will not substantially degrade the performance of the digital radio device as to BER (Bit Error Rate). E.g. for GSM, GSM recommendation 05.05, version 3.5.0, Transmission and Reception, 1.3.89, assumes a static channel condition for RF signal levels between -10 dBm and -40 dBm, for the purpose of BER-measurements. Assuming RF signals with a maximum signal level of -10 dBm in a GSM system, in an embodiment of the present invention input RF signals are hard limited above -40 dBm, in RF and/or IF receiver stages, such a hard limiting being permissible. Hard limiting should be avoided below the signal level of the strongest interferer. The down converted received radio frequency signal is fed to base band conversion means 11 for obtaining base band signals, which are fed to a smooth-non-linear arrangement 12 for achieving base band signal compression in accordance to the present invention. The smooth-non-linear arrangement 12 can comprise true logarithmic amplifiers 13 and 14 for compressing respective quadrature base band signals I and Q, i.e. an in-phase and quadrature signal respectively. Such a true logarithmic amplifier can be a circuit as in an IC with type number SL531C (Plessey), or any other true logarithmic amplifier. Instead of logarithmic amplifiers 13 and 14 the smooth-non-linear arrangement 12 may comprise circuits with a different transfer characteristic, such as a sine-shaped transfer characteristic. The base band conversion means 11 comprise respective base band converters 16 and 17 which are coupled to sine and cosine local oscillators 18 and 19 respectively. The base band conversion means may further comprise respective low pass filters 20 and 21 for low pass filtering the quadrature signals I and Q. After signal compression the base band signals are fed to analog to digital conversion means such as A/D-converters 22 and 23 for obtaining samples of the same. The samples are fed to digital processing means 24 for base band processing. The processed signals, e.g. representing speech signals, are fed via interface logic 25 to a PCM (Pulse Code Modulation) Bus Interface 26 to an handset in which conversion from digital to analog signals is carried out. In case of a speech communication, an analog speech signal is fed to a speaker 28. In opposite direction, in full duplex mode, an analog speech signal picked-up by a microphone is fed to the digital processing means 24 via the interfaces 26 and 25, and is modulated and converted to a radio frequency signal in transmitting means 30 which deliver an signal to an antenna 31 via a diplexer 32. The interface logic is further coupled to a device control unit 33 for generating various control signals within the digital radio device, such as TDMA control. Shown are control signals c1, c2, c3, c4, and c5 for repective control of the local oscillators 8, 18, and 19, and the analog to digital converters 22 and 23. For a more detailed desciption of a known GSM receiver referred is to an article, "Architektur eines Mobilfunkgerätes für das Netz D", P. Schöffel et al., Philips Innovation 1/1991, pp. 132-139.

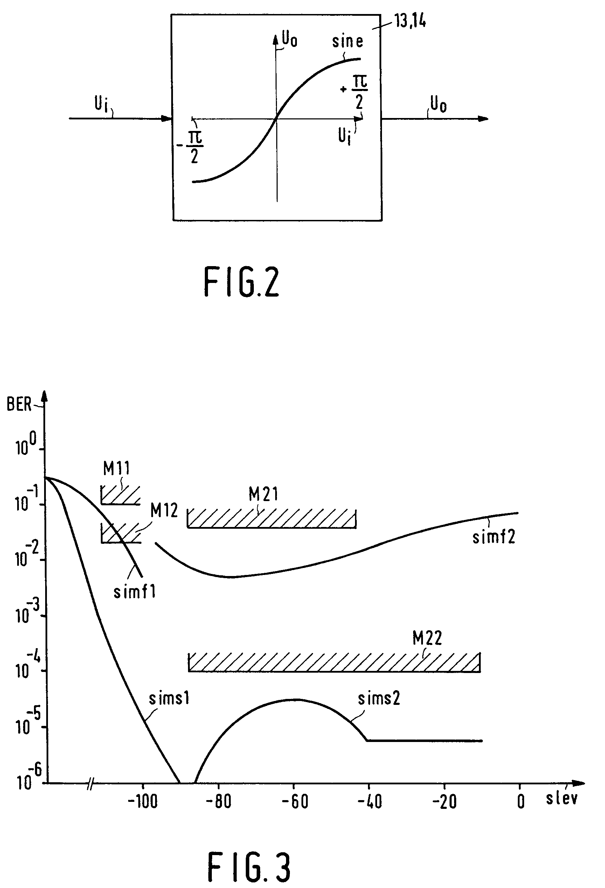

Fig. 2 diagrammatically shows an embodiment of a signal compression device 13 or 14 for use in the digital radio device 2 having a sine-shaped tranfer characteristic sine from -π/2 to +π/2, indicated by an input-output relation Uₒ/Uᵢ of the devices 13 and 14. Such a transfer characteristic sine can be realised and approximated by a number cascaded and/or cascoded amplifier stages having a non-linear transfer characteristic, the resulting transfer characteristic being a polynomial approximation of a sine-shaped transfer characteristic. In applying such a sine-shaped characteristic, lower level input signals are appromately linearly amplified whereas higher level input signals are compressed, and such a compression favours lower level noisy signals as to quantisation in the A/D-converters 22 and 23.

Fig. 3 shows simulation results of bit error rates BER versus signal levels slev in dBm, in a radio device 2 according to the present invention under various channel conditions. The simulations were carried out for a receiver architecture with IF hard limiting above -40 dBm, base band signal compression, and A/D-conversion using 6 bit A/D-converters. Signal compression was done in a signal range between -84 dBm and -40 dBm. Specification masks M11, M12 at -100 dBm, and M21, M22 at higher signal levels are shown. For a test channel behaving like a typical fading channel the BER should not exceed M11 and M21 respectively, and for a test channel like a static test channel the BER should not exceed M12 and M22 respectively. Simulation results for the typical fading channel, indicated with curves simf1 and simf2, and for the static channel, indicated with sims1 and sims2, show that the particular receiver architecture complies with the BER-specifications M11, M12, and M21, M22. Though signal compression increases the BER, the increased BER still complies with the specifications. The receiver architecture according to the present invention allows for a cost saving high level of integration, i.e. from the limiting arrangement 10 circuits can be integrated within one integrated circuit, whereas the signal limiting arrangement 6, the mixer 7, and the local oscillator 8 can be integrated within another integrated circuit, for even more integration.

The digital processing means 24, e.g. a signal processor with RAM and ROM memory with software etc., can be arranged for decompressing the compressed signal, i.e. for correcting the base band samples. In an embodiment the software comprises a lookup-table addressed by the base band signal samples from the A/D-converters 22 and 23, the lookup-table outputting decompressed sample values. Thus, a quasi-linear result is achieved, with a higher quantisation level for lower level noisy signals than for higher level signals.

## Claims

1. A digital radio device (2) comprising an analog receiving part (4) for receiving phase or frequency modulated radio frequency signals coupled to base band conversion means (11) for converting the radio frequency signals to at least one base band signal, analog to digital conversion means (22, 23) for sampling the at least one base band signal, and digital processing means (24) for processing samples of the at least one base band signal, characterised in that the digital radio device (2) comprises a smooth-non-linear arrangement (12) coupled between the base band conversion means (11) and the analog to digital conversion means (22, 23) for compressing larger signals at an input thereof more than smaller signals.

2. A digital radio device (2) as claimed in claim 1, wherein the smooth-non-linear arrangement (12) is a logarithmic amplifier.

3. A digital radio device (2) as claimed in claim 1, wherein the smooth-non-linear arrangement (12) is an arrangement (13, 14) having a sine-shaped transfer characteristic.

4. A digital radio device (2) as claimed in claims 1, 2 or 3, wherein the base band signals are quadrature signals.

5. A digital radio device (2) as claimed in claims 1, 2, 3 or 4, comprising at least one signal limiting arrangement (6, 10) in the analog receiving part (4).

6. A digital radio device (2) as claimed in claim 5, comprising at least one low pass filter (20, 21) for filtering the at least one base band signal.

7. A digital radio receiver (2) as claimed in claims 5 or 6, comprising at least one band pass filter (5, 9) before the at least one signal limiting arrangement (6, 10).

8. A digital radio device (2) as claimed in any one of the preceding claims, wherein the digital processing means (24) are arranged for correcting the samples of the at least one base band signal so as to decompress for compression by means of the smooth-non-linear arrangement (12).

9. A digital radio device (2) as claimed in claim 8, wherein the processing means (24) are arranged for correcting the samples by using the samples as addresses for a correction lookup-table which outputs decompressed sample values.
